**Europäisches Patentamt**

**European Patent Office**

**Office européen des brevets**

(19)

(11) Veröffentlichungsnummer: **0 275 512**
**A1**

(12) # EUROPÄISCHE PATENTANMELDUNG

(21) Anmeldenummer: **87118826.4**

(22) Anmeldetag: **18.12.87**

(51) Int. Cl.⁴: **C25D 5/08** , C25D 5/04

(30) Priorität: **20.12.86 DE 3643746**

(43) Veröffentlichungstag der Anmeldung:
**27.07.88 Patentblatt 88/30**

(84) Benannte Vertragsstaaten:
**ES**

(71) Anmelder: **STOHRER-DODUCO GmbH & Co.**
**Gutenbergstrasse 16**
**D-7255 Rutesheim(DE)**

(72) Erfinder: **Steins, Helmut**
**Johann-Gessner-Staffel 4**
**D-7263 Bad Liebenzell(DE)**

(74) Vertreter: **Twelmeier, Ulrich, Dipl.Phys. et al**
**Westliche Karl-Friedrich-Strasse 29-31**
**D-7530 Pforzheim(DE)**

(54) **Tauchverfahren und Vorrichtung zum elektrolytischen Beschichten von Platten, insbesondere von elektrischen Leiterplatten.**

(57) Es werden ein Tauchverfahren und eine Vorrichtung zum elektrolytischen Beschichten von ruhenden Platten (13),insbesondere von elektrischen Leiterplatten, mit Metall in einem mit einem Elektrolyten angefüllten Behälter (1) beschrieben in welchen wenigstens eine Anode (4) und mit Abstand zu dieser die kathodisch gepolten Platten (13) eintauchen, an deren Oberfläche durch unterhalb der Elektrolytoberfläche (24) erzeugte und gegen die Platten (13) gerichtete Elektrolytstrahlen (25) eine Elektrolytströmung erzeugt wird. Dabei wird das Metall nicht auf allen kathodisch gepolten Bereichen der Platten (13) zugleich, sondern wiederholt in über die Platten (13) wandernden Bereichen abgeschieden und zu diesem Zweck überstreichen die Elektrolytstrahlen (25) die Platten (13).

# FIG. 1

EP 0 275 512 A1

## Tauchverfahren und Vorrichtung zum elektrolytischen Beschichten von Platten, insbesondere von elektrischen Leiterplatten

### Technisches Gebiet:

Die Erfindung geht aus von einem Tauchverfahren mit den im Oberbegriff des Anspruchs 1 angegebenen Merkmalen bzw. von einer Vorrichtung zum Durchführen eines solchen Tauchverfahrens mit den im Oberbegriff des Anspruchs 9 angegebenen Merkmalen.

### Stand der Technik:

Eine solche Vorrichtung ist in der US-PS 4 443 304 beschrieben. Die bekannte Vorrichtung hat einen länglichen Behälter zur Aufnahme eines Elektrolyten. Entlang der Längswände des Behälters sind zwei Reihen von senkrecht angeordneten Anodenstäben angeordnet, welche an elektrischen Leitschienen aufgehängt sind, welche nahe den Längsrändern des Behälters verlaufen. In der Mitte zwischen den beiden Leitschienen für die Anodenstäbe befindet sich eine Kathodenschiene, an welche die zu beschichtenden Leiterplatten angehängt werden. Zu beiden Seiten dieser Stelle, wo die Leiterplatten angehängt werden, befindet sich mit Abstand zu den Anodenstäben eine Reihe von senkrechten Rohren, die durch ein am Behälterboden verlaufendes Speiserohr miteinander verbunden sind und bis über den vorgesehenen Elektrolytspiegel hinausragen. Auf jedem der senkrechten Rohre befindet sich eine Reihe von Düsen, welche schräg gegen die Leiterplatten gerichtet sind, wobei auf gegenüberliegenden Seiten der Leiterplatten liegende Düsen einander zugewandt sind. Den Düsen wird durch eine Umwälzpumpe Elektrolytflüssigkeit zugeführt, so dass über die gesamte Fläche der Leiterplatten verteilt während des Beschichtungsvorganges Elektrolytstrahlen auf diese auftreffen, wobei durch die schräge Anordnung der Düsen im Elektrolytbehälter gleichzeitig eine umlaufende Strömung erzeugt wird. In der bekannten Vorrichtung lassen sich Metalle nicht mit gleichmässiger Schichtdickenverteilung auf Platten abscheiden, weil nicht an allen Stellen der Plattenoberfläche dieselben Abscheidebedingungen herrschen. Dabei kommt einer gleichmässigen Schichtdickenverteilung unter dem Gesichtspunkt der Metalleinsparung und auch unter dem Gesichtspunkt der zunehmenden Miniaturisierung von elektronischen Schaltungen (es werden feinere Leiterbahnen mit 80 μm Breite angestrebt) steigende Bedeutung zu. Ein besonderes Problem ist dabei die Metallabscheidung in Bohrungen von Leiterplatten, denn ungleichmässig dicke Metallabscheidung in den Bohrungen, die bei miniaturisierten Schaltungen vielleicht nur 0,3 mm im Durchmesser betragen, können dazu führen, dass ein Anschluß bein eines elektrischen Bauteils in die betreffende Bohrung nicht mehr eingeführt werden kann oder die Leiterbahn im Bereich der betreffenden Bohrung unterbrochen wird.

### Offenbarung der Erfindung:

Der Erfindung liegt die Aufgabe zugrunde, ein Verfahren und eine Vorrichtung anzugeben, welche sich insbesondere zum elektrolytischen Beschichten von Leiterplatten eignet und das Erzielen gleichmässigerer Schichtdicken gestattet.

Diese Aufgabe wird gelöst durch ein Verfahren mit den im Anspruch 1 angegebenen Merkmalen sowie durch eine Vorrichtung mit den im Anspruch 9 angegebenen Merkmalen. Vorteilhafte Weiterbildungen der Erfindung sind Gegenstand der jeweiligen Unteransprüche.

Das erfindungsgemäße Verfahren unterscheidet sich vom Stand der Technik grundlegend darin, dass das Metall nicht auf allen für die elektrolytische Abscheidung vorgesehenen und vorbereiteten Bereichen der Platten zugleich abgeschieden wird, sondern dass man die Metallabscheidung auf einen Teilbereich der Platten konzentriert und diesen Teilbereich, in dem die Metallabscheidung im wesentlichen stattfindet, wiederholt über die gesamte Oberfläche der Platten wandern läßt, wobei die Elektrolytstrahlen, welche in der Elektrolytflüssigkeit erzeugt werden, diese Wanderbewegung mitmachen und immer in dem Bereich auf die Platten auftreffen, wo die Metallabscheidung gerade stattfinden kann. Der Vorteil des erfindungsgemäßen Verfahrens liegt darin, dass man in einem Teilbereich der zu beschichtenden Platten leichter für gleichmässige Abscheidebedingungen sorgen kann, wobei die Auswirkungen der verbleibenden Ungleichmässigkeiten der Abscheidebedingungen durch das wiederholte Überstreichen der Plattenoberflächen ausgeglichen werden. Auf diese Weise kommt man bereits ohne den Einsatz von in ihrer optimalen Gestalt schwer zu bestimmenden Anodenblenden zu einer gleichmässigen Schichtdickenverteilung der Metallabscheidung auf der Plattenoberfläche. Dieser Vorteil muss weder durch eine vergrößerte oder aufwendigere Beschichtungsvorrichtung noch durch verlängerte Beschichtungszeiten erkauft werden. Vielmehr sind durch die intensive Einwirkung der Elektrolytstrahlen auf die zu beschichtenden Oberflächen hohe Stromdichten (bis ca. 30 A dm²) und damit hohe Abscheidegeschwindigkeiten möglich.

Bei den üblichen Rechteckformaten der Platten ist die Bewegung der Elektrolytstrahlen am besten eine hin-und hergehende Bewegung, welche parallel zu einem der Ränder der Platten erfolgt. Die Elektrolytstrahlen richtet man dabei am besten senkrecht gegen die Platten, weil dadurch besonders wirksam die Ausbildung eines an Metallionen verarmten Kathodenfilmes verhindert werden kann. Ausserdem kann bei senkrechter Anströmung der Platten besser als bei schräger Anströmung, wie sie die US-PS 4 443 304 zeigt, ein Elektrolytaustausch in Bohrungen der Platten stattfinden, so dass in den Bohrungen die Abscheidegeschwindigkeit erhöht und die Ausbildung einer gleichmässig dicken Beschichtung begünstigt wird. Wenn die Platten beidseitig beschichtet werden sollen und aus diesem Grund die Elektrolytstrahlen von beiden Seiten gegen die Platten gerichtet werden, dann richtet man sie am besten in der Weise versetzt gegen die Platten, dass dann, wenn auf eine Seite einer Platte an einer Stelle ein Elektrolytstrahl auftrifft, an der genau gegenüberliegenden Stelle auf der anderen Seite der Platte nicht gleichzeitig ein Elektrolytstrahl auftrifft. Eine solche versetzte Führung der Elektrolytstrahlen ist bei gelochten Platten vorteilhaft, weil ein jedes Loch dann nicht gleichzeitig von beiden Seiten von einem Elektrolytstrahl getroffen wird, sondern mal von der einen Seite und mal von der anderen Seite, und dabei kann jedesmal eine durch das Loch hindurchführende Elektrolytströmung stattfinden, die verhindert wäre, wenn gleichzeitig von beiden Seiten Elektrolytstrahlen auftreffen würden.

Vorzugsweise werden Zeilen von Elektrolytstrahlen gebildet, die parallel zu einem der Ränder der Platten ausgerichtet sind, und diese Zeilen läßt man dann quer zu ihrer Längsrichtung über die Platten wandern, wodurch es möglich ist, eine Platte vollständig zu überstreichen. Zweckmässigerweise bildet man auf jeder der zu beschichtenden Seiten der Platten zwei parallele Zeilen von Elektrolytstrahlen, die rechtwinklig zum Verlauf der Zeilen parallel zu den Platten synchron über diese hinweg bewegt werden. Dabei richtet man die Elektrolytstrahlen am besten so aus, dass die Elektrolytstrahlen der einen Zeile gegenüber den Elektrolytstrahlen der anderen Zeile bezogen auf die Bewegungsrichtung der Zeilen versetzt erzeugt werden, insbesondere so, dass zwischen den Wegen zweier benachbarter Elektrolytstrahlen aus der einen Zeile der Weg eines Elektrolytstrahls aus der anderen Zeile liegt. Eine solche Anordnung trägt zur gleichmässigen Ausbildung der Dicke der abgeschiedenen Metallschicht bei.

Wie die Platten im Elektrolytbehälter angeordnet sind und in welcher Richtung die Zeilen der Elektrolytstrahlen verlaufen, ist im Grunde genommen gleichgültig. Die vorrichtungsmässige Verwirklichung des Verfahrens ist jedoch etwas einfacher, wenn die Zeilen waagerecht verlaufen und die Platten lotrecht angeordnet werden.

Die erfindungsgemäße Vorrichtung zum elektrolytischen Beschichten von Platten umfaßt in üblicher Weise einen Behälter zur Aufnahme des Elektrolyten, in welchem wenigstens eine Anode - wenn die Platten beidseitig beschichtet werden sollen, wenigstens zwei einander gegenüberliegende Anoden - angeordnet sind. Zum Eintauchen der zu beschichtenden Platten ist in einem Abstand von den Anoden eine Halterung vorgesehen; für den Fall, dass die Vorrichtung zum beidseitigen Beschichten von Platten dient, befindet sich die Halterung mitten zwischen den einander gegenüberliegenden Anoden. Zwischen den Anoden und jener durch die Lage der Halterung vorgegebenen Ebene, in welcher die zu beschichtenden Platten angeordnet werden, befinden sich gegen die genannte Ebene gerichtete Düsen, denen durch eine Pumpe Elektrolytflüssigkeit zugeführt wird; es handelt sich dabei zweckmässigerweise um eine Umwälzpumpe, welche die Elektrolytflüssigkeit an einer Stelle des Behälters ansaugt und dann den Düsen zuführt. Anders als beim Stand der Technik (US-PS 4 443 304) sind die Düsen und die Anoden nicht ortsfest angeordnet, vielmehr sind die Anoden und die ihnen benachbarten Düsen parallel zu der Ebene im Behälter, die für die Anordnung der Platten vorgesehen ist, verschiebbar. Es handelt sich dabei nicht um eine Verschiebbarkeit zum Zwecke einer einmaligen Justierung, wie um die optimale Lage der Düsen und Anoden aufzufinden, vielmehr sind die Düsen und die ihnen zugeordneten Anoden motorisch antreibbar, damit sie während des Beschichtungsvorganges eine parallel zu den Platten verlaufende, hin-und hergehende Bewegung vollführen, in deren Verlauf sie die Platten mehrfach überstreichen. Die Düsen und Anoden sind deshalb nicht wie bei der aus der US-PS 4 443 304 bekannten Vorrichtung über die gesamten Längswände des Elektrolytbehälters verteilt angeordnet, sondern nur in einem relativ schmalen Bereich, vorzugsweise parallel zu den Längsrändern des Eletrolytbehälters. In einem solchen relativ schmalen Bereich lassen sich leichter gleichmässige Abscheidebedingungen verwirklichen als bei Erstreckung der Düsen und Anoden über einen mehrfach größeren Bereich, wobei verbleibende Unterschiede in den Abscheidebedingungen durch das Verschieben der Düsen und Anoden über die Platten hinweg noch ausgeglichen werden können.

Die Düsen und Anoden sind zweckmässigerweise senkrecht auf und ab verschiebbar und zu diesem Zweck sind die Düsen vorzugsweise in einer oder mehreren waagerechten Zeilen angeordnet, vorzugsweise in zwei zueinander parallelen Zeilen auf jeder Seite der Platte, die beschichtet werden soll. Man kann dann mit Vorteil die Düse in zwei auf derselben Seite einer Platte liegenden Zeilen so anordnen, dass bezogen auf die Verschieberichtung die Düsen der einen Zeile gegenüber den Düsen der anderen Zeile versetzt sind, so dass der aus einer Düse der einen Zeile austretende Elektrolytstrahl längs eines Weges auf der zu beschichtenden Platte seine maximale Wirkung ausübt, auf welchem die benachbarten Düsen der anderen Zeile eine geringere Wirkung entfalten. Durch die aufeinanderfolgende Einwirkung der Düsen der einen Zeile und der anderen Zeile gleichen sich die Unterschiede in der Einwirkung aus, wodurch eine gleichmässige Schichtdicke der abgeschiedenen Metallschicht begünstigt wird.

Vorzugsweise ordnet man auch die auf verschiedenen Seiten der Ebene, die für die Anordnung der Platten im Behälter vorgesehen ist, liegenden Düsen, welche einander zugewandt sind, so gegeneinander versetzt an, dass keine Düse einer anderen Düse genau gegenüberliegt. Beim Beschichten von gelochten Leiterplatten hat das den Vorteil zur Folge, dass die Löcher nicht gleichzeitig von beiden Seiten von einem Elektrolytstrahl getroffen werden, sondern abwechselnd von der einen Seite und von der anderen Seite, wodurch ein Elektrolytaustausch in den Löchern begünstigt wird.

Um zu gewährleisten, dass eine elektrolytische Abscheidung unter definierten Bedingungen im wesentlichen nur in dem Bereich der Platten stattfindet, der augenblicklich von den Düsen beaufschlagt wird, befinden sich die Anoden vorzugsweise in einem elektrisch isolierenden, mit ihnen mitbewegten Gehäuse, welches aussen auf seiner den Platten zugewandten Wand die Düsen trägt und in der Nachbarschaft der Düsen durchbrochen ist. Durch die Durchbrechungen ist ein Ladungsträgerstrom von den Anoden zu den als Kathode geschalteten Platten möglich, wobei durch die Lage der Durchbrechungen in der Nachbarschaft der Düsen dafür gesorgt ist, dass der Ladungsträgertransport tatsächlich zu jenen Bereichen der Platten erfolgt, die gerade von den Düsen beaufschlagt werden. Die Durchbrechungen könnten durch eine Anzahl von Löchern gebildet sein. Vorzugsweise sieht man jedoch stattdessen einen parallel zur Düsenzeile verlaufenden Schlitz vor, der sich annähernd über die volle Länge des Gehäuses erstreckt. Für den Fall, dass auf einer oder auf beiden Seiten der Platten zwei Zeilen von Düsen vorgesehen sind, ordnet man diese vorzugsweise so an, dass der Schlitz durch diese zwei Zeilen begrenzt ist. Am besten bildet man die Düsen an einem Rohr aus, welches sie miteinander verbindet und der Elektrolytzuführung dient. Ist das Rohr aus Metall, dann kann es als Blende wirken, welche das von den Anoden ausgehende elektrische Feld teilweise abschirmt und dafür sorgt, dass nur der durch den Schlitz des Gehäuses hindurchgreifende Teil des elektrischen Feldes für die elektrolytische Abscheidung wirksam wird. Um das elektrische Feld unterschiedlich stark abschirmen zu können, ist die - in Bewegungsrichtung der Düsen gemessene - Breite des Schlitzes zweckmäßigerweise veränderbar. Zur Anpassung an unterschiedlich große Platten oder Felder von Platten ist der Schlitz vorzugsweise auch in der Länge veränderbar, insbesondere durch eine verschiebbare Blende. Dadurch kann die Streuung des elektrischen Feldes am Rand der Platte bzw. des Feldes aus Platten zur Erzielung optimal gleichmässiger Abscheidebedingungen an deren Format angepaßt werden.

Vorzugsweise ordnet man die Anoden nicht unmittelbar hinter dem Schlitz an, sondern in einigem Abstand dahinter, so dass durch den Schlitz und die ihn begrenzenden metallischen Rohre eine vorteilhafte Bündelungswirkung für den Ladungsträgerstrom erzielt wird. Die Anoden selbst brauchen dabei nicht oder nur wenig größer zu sein, als es die Anordnung der Durchbrechungen des Gehäuses ist. Derart kleine Anoden haben überdies den Vorteil, dass sie leichter regeneriert werden können.

Vorzugsweise haben die Gehäuse, in denen die Anoden angeordnet sind, zusätzlich zu den bei den Düsen liegenden Durchbrechungen noch Öffnungen in den beiden quer zur Verschieberichtung liegenden Wänden. Diese zusätzlichen Öffnungen erleichtern den Elektrolytaustausch in dem jeweiligen Gehäuse, ohne die Gleichmässigkeit der Metallabscheidung zu beeinträchtigen.

Ein Ausführungsbeispiel der Erfindung ist in den beigefügten Zeichnungen schematisch dargestellt.

Kurze Beschreibung der Zeichnungen:

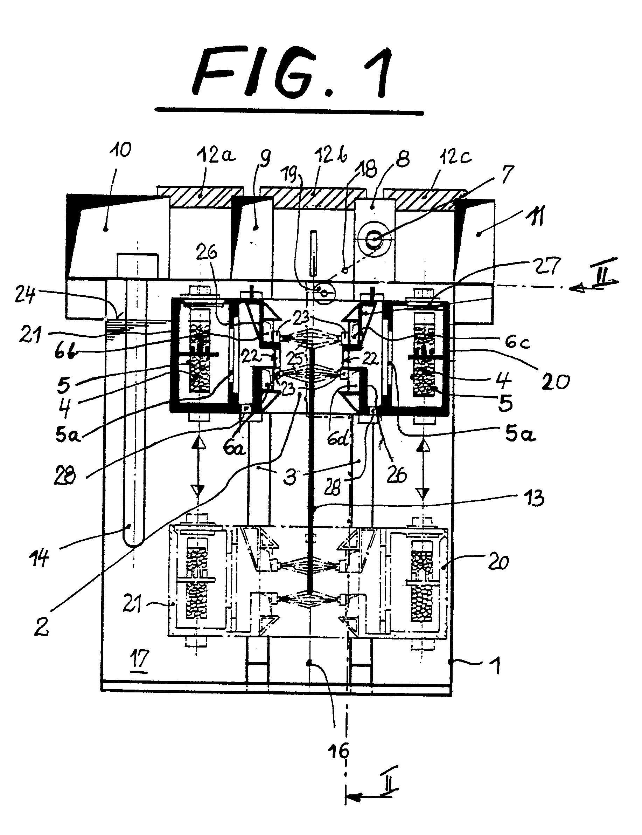

Fig. 1 zeigt eine Vorrichtung zum elektrolytischen Beschichten von Platten mit Metall in einem vertikalen Querschnitt,

Fig. 2 zeigt die Vorrichtung in einem vertikalen Längsschnitt längs der Linie II-II in Fig. 1,

Fig. 3 zeigt als Detail im Querschnitt den Bereich der Düsen eines vertikal verfahrbaren Gehäuses in der Vorrichtung,

Fig. 4 zeigt schematisch die Ansicht wie in Fig. 2 auf einen Schlitz mit einer verschiebbaren Blende darin,

Fig. 5 zeigt eine schematische Darstellung des Beschickungsfensters der Vorrichtung, und

Fig. 6 zeigt den Hub des Gehäuses mit den Düsen in der Vorrichtung bei unterschiedlich großem Beschickungsfenster.

Detaillierte Beschreibung der Zeichnungen mit Wegen zur Ausführung der Erfindung:

Die Vorrichtung weist einen quaderförmigen Behälter 1 mit einem versteiften Rand 1a auf. Auf dem Behälter 1 verlaufen in Längsrichtung mit Abstand nebeneinander ein Installationskanal 10, von dem aus z.B. ein Heizstab 14 und/oder Meßfühler zur Überwachung des Zustandes der in den Behälter eingefüllten Elektrolytflüssigkeit in den Behälter 1 eintauchen, ein Absaugkanal 9 zum Absaugen von verdampfter Elektrolytflüssigkeit, ein Schutzkasten 8 für eine Antriebswelle 7 und ein Abschlußkasten 11. Dazwischen sind drei abnehmbare Deckel 12a, 12b und 12c angeordnet, durch welche das Innere des Behälters 1 zugänglich ist.

Eine kathodisch gepolte Platte 13 oder eine durch eine Halterung gehaltene ebene Anordnung mehrerer solcher Platten, bei denen es sich um Vorprodukte für elektrische Leiterplatten handeln kann, ist in einer vorgegebenen Ebene 16 mitten unter dem mittleren Deckel 12b senkrecht in den Behälter 1 eingehängt. Die Ausbildung der Halterung für solche Platten 13 ist Stand der Technik und aus Gründen der Übersichtlichkeit nicht im einzelnen dargestellt.

Beidseits der Ebene 16 befinden sich in gleichen Abständen von dieser je zwei vertikale Hubschlittenführungen 3 an den schmalen Behälterwänden 17; längs diesen Hubschlittenführungen 3 ist an jeder der beiden - schmalen Behälterwände 17 ein Hubschlitten 2 auf und ab verfahrbar. Zum Antrieb der Hubschlitten 2 dient die Antriebswelle 7, von welcher ein Riemen 18 über eine Umlenkrolle 19 zum Hubschlitten 2 geführt und daran befestigt ist.

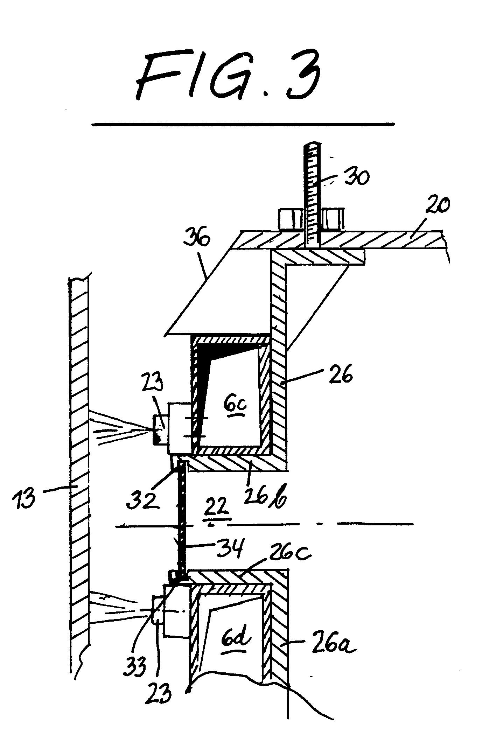

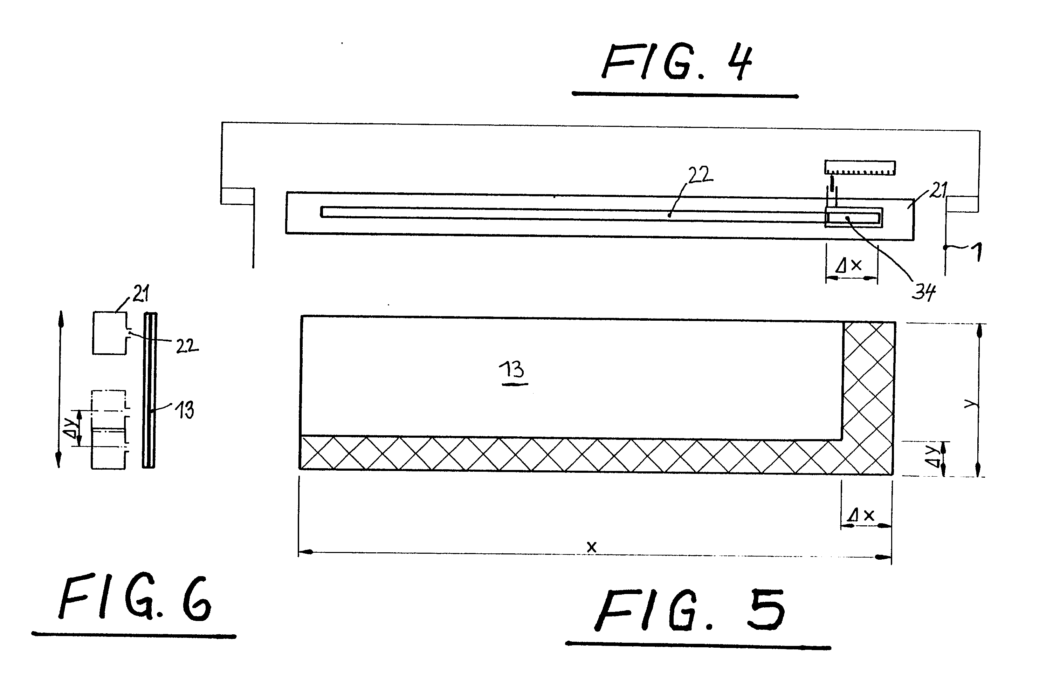

Die beiden Hubschlitten 2 sind durch zwei gleiche, spiegelbildlich zur Ebene 16 angeordnete Gehäuse 20 und 21 aus Kunststoff, z.B. aus Polypropylen, starr miteinander verbunden. In den Gehäusen 20 und 21 befinden sich Anoden 4, welche z.B. durch Titankörbe mit einer aus Kupferkugeln be stehenden Füllung gebildet und von einem unter Verwendung eines Kunststoffgewebes, insbesondere eines Polypropylengewebes, hergestellten Anodenkorb 5 umgeben sind. Die Anoden 4 befinden sich im Gehäuse 20 bzw. 21 nahe bei dessen der Ebene 16 abgewandten Gehäusewand, während in der der Ebene 16 zugewandten Gehäusewand ein längsverlaufender, durchgehender Schlitz 22 vorgesehen ist. Unmittelbar angrenzend an den Schlitz 22 sind auf der Aussenseite des einen Gehäuses 20 wie des anderen Gehäuses 21 je zwei auf Z-förmigen, zugleich als Anodenblenden dienenden Metallprofilen 26, 26a gehaltene Rohre 6a, 6b, 6c, 6d angrenzend an eine der Führung dienende Schrägfläche 36 angeordnet, die auf ihrer der Ebene 16 zugewandten Seite in regelmässigen Abständen mit Düsen 23 versehen sind (siehe auch Fig. 3). Die Z-Profile 26 sind durch Stellschrauben 30 höhenverstellbar am Gehäuse 20 bzw. 21 angebracht, wodurch die Breite des Schlitzes 22 verstellbar ist. Ausserdem befindet sich in der Unterseite des unteren Schenkels 26b des oberen Z-Profils 26 eine längsverlaufende Nut 32, und dieser gegenüberliegend befindet sich in der Oberseite des oberen Schenkels 26d des unteren Z-Profils 26a eine der Nut 32 gegenüberliegende Nut 33. In den beiden Nuten 32 und 33 ist eine streifenförmige metallische Blende 34 zur Änderung der wirksamen Länge des Schlitzes 22 verschiebbar angeordnet. Dadurch kann die Länge des Schlitzes 22 der von Fall zu Fall variierenden Länge X einer Anordnung von Platten 13 angepaßt werden (siehe Fig. 4, wo zur Vereinfachung der Darstellung die Düsen samt den Rohren, auf denen sie sich befinden, nicht dargestellt sind).

Die Anpassung an unterschiedliche Höhen Y der Anordnung von Platten 13 kann einfach zur Änderung des Hubs der Hubschlitten 2 erfolgen. Die durch die Länge X und die Höhe Y definierte Fläche bezeichnet man auch als das Beschickungsfenster der Vorrichtung; es ist in Fig. 5 dargestellt. Es wird zweckmäßigerweise so gelegt, dass - wie in Fig. 5 dargestellt - zwei Seiten des Fensters ihre Lage stets beibehalten und nur die beiden übrigen Seiten angepaßt werden. Die Blende 34 wird deshalb nur an einem Ende des Schlitzes 22 benötigt. Der Schlitz 22 wird etwas kürzer als die Länge X des Fensters gewählt; er endet - abhängig vom Abstand des Schlitzes 22 von den Platten 13 - größenordnungsmässig 100 mm vor dem Rand des Fensters. Die Fläche, um die das Fenster geändert werden kann, ist in Fig. 5 kreuzweise schraffiert. Die Rohre 6a bis 6d sind mit ihren Enden an den Hubschlitten 2 befestigt und über nicht dargestellte flexible Schläuche mit einer ebenfalls nicht dargestellten Umwälzpumpe verbunden, welche Elektrolytflüssigkeit ansaugt und aus den Düsen 23 wieder austreten läßt. Dadurch entstehen unterhalb des Spiegels 24 der Elektrolytflüssigkeit Elektrolytstrahlen 25, welche ungefähr rechtwinklig auf die Platte 13 auftreffen.

Der Bereich der Platten 13, in welchem momentan eine Metallabscheidung stattfindet, ist begrenzt durch die Lage der oberen und unteren Zeile von Elektrolytstrahlen 25, und dieser streifenförmige Bereich wandert auf und ab über die Platten 13, so wie die Hubschlitten 2 auf und ab bewegt werden. Die Geschwindigkeit der Hubschlitten 2 ist vorzugsweise zwischen 1 m/min und 10 m/min einstellbar. Um den Elektrolytaustausch in den Gehäusen 20, 21 zu fördern, haben diese in ihrer oberen und unteren Wand zusätzliche Öffnungen 27 und 28. Durch die Öffnung 27 ist zugleich eine Zugangsmöglichkeit zu den Anoden 4 gegeben.

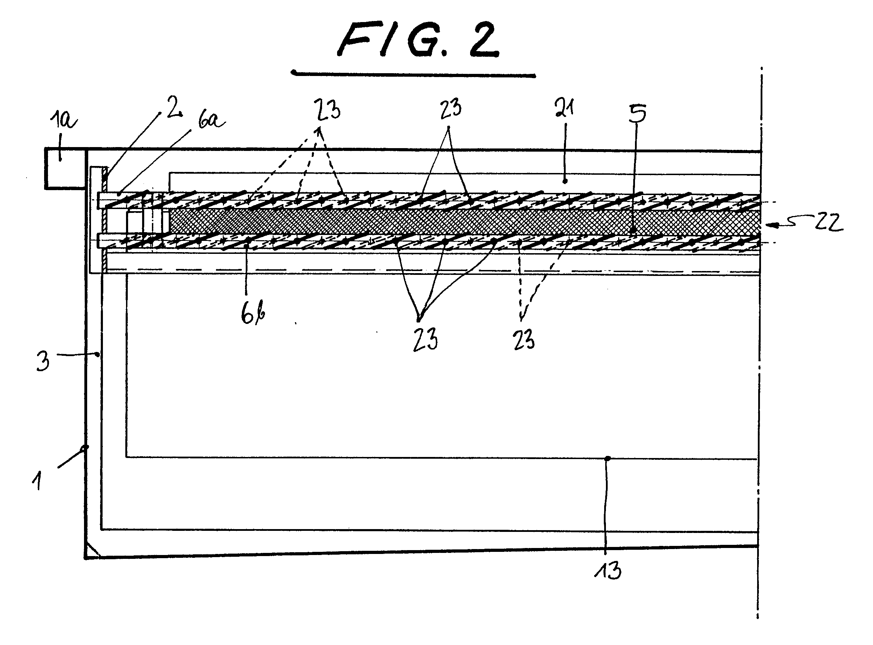

Anhand der Fig. 2 erkennt man, dass die Düsen 25 gegeneinander versetzt angeordnet sind. Bezogen auf die Bewegungsrichtung der Düsen 25 befindet sich zwischen je zwei benachbarten Düsen 25 des unteren Rohrs 6a eine Düse 25 des oberen Rohrs 6b und umgekehrt. Entsprechendes gilt für die Rohre 6c und 6d. Die Lage der Düsen der Rohre 6c und 6d ist in Fig. 2 gestrichelt angedeutet. Man sieht daraus, dass keine zwei Düsen 25 einander gegenüberliegen. Im Gegensatz zu gattungsfremden Vorrichtungen, in denen Platten oder Bänder im Durchlauf beschichtet werden, wird in die erfindungsgemäße Vorrichtung die Platte 13 von oben eingeführt, in Ruhe beschichtet, und wieder nach oben herausgezogen.

## Ansprüche

1. Tauchverfahren zum elektrolytischen Beschichten von ruhenden Platten, insbesondere von elektrischen Leiterplatten, mit Metall in einem mit einem Elektrolyten angefüllten Behälter, in welchen wenigstens eine Anode und mit Abstand zu dieser die kathodisch gepolten Platten eintauchen, an deren Oberfläche durch unterhalb der Elektrolytoberfläche erzeugte und gegen die Platten gerichtete Elektrolytstrahlen eine Elektrolytströmung erzeugt wird, dadurch gekennzeichnet, dass das Metall nicht auf allen kathodisch gepolten Bereichen der Platten zugleich, sondern wiederholt in über die Platten wandernden Bereichen abgeschieden wird und zu diesem Zweck die Elektrolytstrahlen die Platten überstreichen.

2. Verfahren nach Anspruch 1, dadurch gekennzeichnet, dass die Elektrolytstrahlen die Platten hin-und hergehend überstreichen.

3. Verfahren nach Anspruch 1 oder 2, dadurch gekennzeichnet, dass die Elektrolytstrahlen senkrecht gegen die Platten gerichtet werden.

4. Verfahren nach Anspruch 1, 2 oder 3, dadurch gekennzeichnet, dass Elektrolytstrahlen von beiden Seiten gegen die Platten gerichtet werden.

5. Verfahren nach Anspruch 4, dadurch gekennzeichnet, dass die Elektrolytstrahlen in der Weise versetzt gegen die Platten gerichtet werden, dass, wenn auf einer Seite einer Platte an einer Stelle ein Elektrolytstrahl auftrifft, an der genau gegenüberliegenden Stelle auf der anderen Seite der Platte nicht gleichzeitig ein Elektrolytstrahl auftrifft.

6. Verfahren nach einem der Ansprüche 1 bis 5, dadurch gekennzeichnet, dass auf jeder der zu beschichtenden Seiten der Platten zwei parallele Zeilen von Elektrolytstrahlen gebildet werden, die rechtwinklig zum Verlauf der Zeilen parallel zu den Platten hin-und hergehend über diese hinwegbewegt werden.

7. Verfahren nach Anspruch 6, dadurch gekennzeichnet, dass die Zeilen waagerecht verlaufen und die Platten lotrecht angeordnet werden.

8. Verfahren nach Anspruch 6 oder 7, dadurch gekennzeichnet, dass die Elektrolytstrahlen der einen Zeile bezogen auf die Bewegungsrichtung der Zeilen versetzt zu den Elektrolytstrahlen der anderen Zeile erzeugt werden.

9. Vorrichtung zum elektrolytischen Beschichten von ruhenden Platten, insbesondere von elektrischen Leiterplatten, mit Metall nach einem Tauchverfahren,

mit einem Behälter zur Aufnahme eines Elektrolyten, in welchem wenigstens eine Anode angeordnet ist,

mit einer Halterung zum Eintauchen der kathodisch gepolten Platten in lotrechter Lage in den Elektrolyten,

und mit unterhalb des Elektrolytspiegels im Behälter zwischen den Anoden und der für die Anordnung der Platten vorgesehenen Ebene angeordneten, gegen die eine und/oder die andere Oberfläche der Platten gerichteten Düsen, denen durch eine Pumpe Elektrolytflüssigkeit zugeführt wird zum Erzeugen einer Elektrolytströmung,

dadurch geknnzeichnet,

dass die Düsen (23) zum Vollführen einer wiederholt hin-und hergehenden Bewegung parallel zu der senkrechten Ebene (16) im Behälter (1), die für die Anordnung der Platten (13) vorgesehen ist, antreibbar sind,

und dass die Anoden (4) synchron mit den ihnen benachbarten Düsen (23) parallel zu diesen verschiebbar sind.

10. Vorrichtung nach Anspruch 9, dadurch gekennzeichnet, dass die Düsen (23) und Anoden (4) senkrecht auf und ab verschiebbar sind.

11. Vorrichtung nach Anspruch 9 oder 10, dadurch gekennzeichnet, dass die Düsen (23) in einer oder mehreren rechtwinklig zu ihrer Verschieberichtung verlaufenden Zeilen angeordnet sind.

12. Vorrichtung nach Anspruch 11, dadurch gekennzeichnet, dass auf einer Seite oder zu beiden Seiten der Ebene (16) im Behälter (1), die für die Anordnung der Platten (13) vorgesehen sind, zwei zueinander parallele Zeilen von Düsen (23) vorgesehen sind.

13. Vorrichtung nach Anspruch 12, dadurch gekennzeichnet, dass alle Düsen (23) den gleichen Abstand von der Ebene (16) im Behälter (1) haben, die für die Anordnung der Platten (13) vorgesehen ist.

14. Vorrichtung nach einem der Ansprüche 9 bis 13, dadurch gekennzeichnet, dass auf verschiedenen Seiten der Ebene (16), die für die Anordnung der Platten (13) im Behälter (1) vorgesehen ist, liegende Düsen (23) so gegeneinander versetzt sind, dass keine Düse (23) einer anderen Düse (23) genau gegenüberliegt.

15. Vorrichtung nach Anspruch 12 oder nach Anspruch 12 und 14, dadurch gekennzeichnet, dass die Düsen (23) der einen Zeile von zwei benachbarten Zeilen, bezogen auf ihre Verschieberichtung gegenüber den Düsen (23) der anderen Zeile versetzt angeordnet sind.

16. Vorrichtung nach einem der Ansprüche 8 bis 15, dadurch gekennzeichnet, dass sich die Anoden (4) in einem elektrisch isolierenden, mit ihnen mitbewegten Gehäuse (20, 21) befinden, welches aussen auf seiner der Ebene (16), die für die Anordnung der Platten (13) im Behälter (1) vorgesehen ist, zugewandten Wand die Düsen (23) trägt und in der Nachbarschaft der Düsen (23) durchbrochen ist.

17. Vorrichtung nach Anspruch 11 und 16, dadurch gekennzeichnet, dass die Durchbrechung des Gehäuses (1) ein parallel zur Zeile der Düsen (23) verlaufender Schlitz (22) ist.

18. Vorrichtung nach Anspruch 12 und 17, dadurch gekennzeichnet, dass der Schlitz (22) durch zwei Zeilen von Düsen (23) begrenzt ist.

19. Vorrichtung nach Anspruch 18, dadurch gekennzeichnet, dass die (in senkrechter Richtung gemessene) Breite des Schlitzes (22) veränderbar ist.

20. Vorrichtung nach Anspruch 16, 17, 18 oder 19, dadurch gekennzeichnet, dass die der Ebene (16), in der die Platten (13) im Behälter (1) angeordnet werden, zugewandte Anodenfläche in ihren Abmessungen nicht oder nur wenig größer ist als die Durchbrechung(en) (22) des Gehäuses (1).

21. Vorrichtung nach einem der Ansprüche 16 bis 19, dadurch gekennzeichnet, dass die Durchbrechung(en) (22) des Gehäuses (1) durch Teile (26) oder Bereiche des Gehäuses (1) aus Metall begrenzt sind.

22. Vorrichtung nach Anspruch 21, dadurch gekennzeichnet, dass eine verstellbare metallische Blende ( 34) vorgesehen ist, durch welche zur Veränderung der wirksamen Länge der Durchbrechung(en) (22) ein Teil der Durchbrechung(en) am einen Ende oder am anderen Ende oder an beiden Enden des Gehäuses (1) abdeckbar ist.

23. Vorrichtung nach Anspruch 17 und 22, dadurch gekennzeichnet, dass die Blende (34) ein den Schlitz (22) verkürzender Schieber ist.

24. Vorrichtung nach einem der Ansprüche 16 bis 23, dadurch gekennzeichnet, dass das Gehäuse (20, 21) zusätzlich Öffnungen (27, 28) in den beiden quer zur Verschieberichtung liegenden Wänden hat.

# FIG. 1

# FIG. 2

0 275 512

# FIG.3

# FIG. 4

# FIG. 6

# FIG. 5

0 275 512

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| X | CH-A- 215 409 (RAUSSER) <br> * Figur 5 * <br> --- | 1-3,9, 10 | C 25 D 5/08 <br> C 25 D 5/04 |
| A,D | US-A-4 443 304 (EIDSCHUN) <br> ----- | | |

RECHERCHIERTE SACHGEBIETE (Int. Cl.4)

C 25 D
H 05 K

Der vorliegende Recherchenbericht wurde für alle Patentansprüche erstellt

| Recherchenort | Abschlußdatum der Recherche | Prüfer |
|---|---|---|
| DEN HAAG | 22-03-1988 | NGUYEN THE NGHIEP |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus andern Gründen angeführtes Dokument
....................................................................
& : Mitglied der gleichen Patentfamilie, übereinstimmendes Dokument

EPO FORM 1503 03.82 (P0403)